# EUROPEAN PATENT APPLICATION

(11) **EP 2 846 360 A1**
(43) Date of publication of application: **11.03.2015**
(21) Application number: 14182799.8
(22) Date of filing: 29.08.2014
(51) Int. Cl.: H01L 31/0224, H01L 31/05, H01L 31/02

(54) **Solar cell module, solar cell and method of manufacturing the same**

(30) Priority: 04.09.2013 JP 2013182911
(71) Applicant: Sanyo Electric Co., Ltd., Moriguchi-shi, Osaka 570-8677 (JP)
(72) Inventor: Sato, Shoji, Moriguchi City,, Osaka 570-8677, (JP)
(74) Representative: Glawe, Delfs, Moll

(57) **Abstract**

A solar cell module includes: adjacent solar cells; and a wiring member electrically connects the adjacent solar cells to each other with resin adhesive. Each solar cell includes: a photoelectric conversion body: a finger electrode provided on a principal surface of the photoelectric conversion body; and an adhesion assistance portion provided at a position where the wiring member overlaps with a photoelectric conversion body when being electrically connected to the solar cell with the resin adhesive, the adhesion assistance portion containing an inorganic particle other than a conductive particle contained in the finger electrode.

## Description

### CROSS REFERENCE TO RELATED APPLICATIONS

This application claims priority from prior Japanese Patent Applications No. 2013-182911, filed on September 4, 2013, entitled "SOLAR CELL MODULE, SOLAR CELL AND METHOD OF MANUFACTURING THE SAME", the entire contents of which are incorporated herein by reference.

### BACKGROUND OF THE INVENTION

### 1. Field of the Invention

This disclosure relates to a solar cell module, a solar cell, and a method of manufacturing the solar cell.

### 2. Description of Related Art

A solar cell module has a configuration in which multiple solar cells are connected to each other in serial or in parallel via wiring members. Bus bar electrodes and Finger electrodes extending in a direction intersecting the bus bar electrodes are usually formed on a principal surface of the solar cell. In general, the wiring members are electrically connected to the bus bar electrodes. In order to improve adhesive strength between a wiring member and a bus bar electrode when they are connected with a resin adhesive, it has been proposed to provide an auxiliary electrode portion near the bus bar electrode (Refer to Japanese Patent Application Publication No.2011-49525, for example).

### SUMMARY OF THE INVENTION

The auxiliary electrode portion is generally made of the same material as the material for the bus bar electrodes and the finger electrodes, and is formed at the same time as the formation of the bus bar electrodes and the finger electrodes. The bus bar electrodes and the finger electrodes contain an expensive conductive material such as silver. Thus, the formation of the auxiliary electrode portion may result in an increase of manufacturing costs of the solar cell.

An object of an embodiment of the invention is to provide a solar cell module, a solar cell, and a method of manufacturing the solar cell, which can achieve improvement of the reliability in connection between a wiring member and a solar cell without being provided with an auxiliary electrode portion.

### Solution to Problem

A first aspect of the invention is a solar cell module includes: adjacent solar cells; and a wiring member electrically connects the adjacent solar cells to each other with resin adhesive. Each solar cell includes: a photoelectric conversion body: a finger electrode provided on a principal surface of the photoelectric conversion body; and an adhesion assistance portion provided at a position where the wiring member overlap with a photoelectric conversion body when being electrically connected to the solar cell with the resin adhesive, the adhesion assistance portion containing an inorganic particle other than a conductive particle contained in the finger electrode.

A second aspect of the invention is a solar cell to be electrically connected to an adjacent solar cell via a wiring member. The solar cell includes: a photoelectric conversion body: a finger electrode provided on a principal surface of the photoelectric conversion body; and an adhesion assistance portion provided at a position where the wiring member is to be overlapped with the photoelectric conversion body when being electrically connected to the solar cell with a resin adhesive, the adhesion assistance portion containing an inorganic particle other than a conductive particle contained in the finger electrode.

A third aspect of the invention is a method of manufacturing a solar cell to be electrically connected to an adjacent solar cell via a wiring member. The method includes: forming a finger electrode on a principal surface of a photoelectric conversion body; and providing an adhesion assistance portion on the photoelectric conversion body at a position to be overlapped with the wiring member, the adhesion assistance portion containing an inorganic particle other than a conductive particles contained in the finger electrode.

The above aspect (s) of the invention can provide a solar cell module with improved reliability in connection between a wiring member and a solar cell without being provided with an auxiliary electrode portion.

### BRIEF DESCRIPTION OF DRAWINGS

Fig. 1 is a schematic plan view illustrating a first principal surface (light receiving surface) of a solar cell in accordance with First embodiment.
Fig. 2 is a schematic enlarged plan view illustrating bus bar electrodes, finger electrodes, and adhesion assistance portions in First embodiment.
Fig. 3 is a schematic sectional view illustrating connection of the wiring members between adjacent solar cells in a solar cell module in First embodiment.
Fig. 4 is a schematic plan view illustrating a first principal surface (light receiving surface) of a solar cell in accordance with Second embodiment.
Fig. 5 is a schematic sectional view illustrating the solar cell in Second embodiment.
Fig. 6 is a schematic enlarged plan view illustrating bus bar electrodes, finger electrodes, and adhesion assistance portions in Third embodiment.
Fig. 7 is a schematic enlarged plan view illustrating bus bar electrodes, finger electrodes, and adhesion assistance portions in Fourth embodiment.
Fig. 8 is a schematic enlarged plan view illustrating bus bar electrodes, finger electrodes, and adhesion assistance portions in Fifth embodiment.
Fig. 9 is a schematic enlarged plan view illustrating bus bar electrodes, finger electrodes, and adhesion assistance portions in Sixth embodiment.

### DETAILED DESCRIPTION OF EMBODIMENTS

Preferred embodiments are described below. It is noted that the embodiments are merely examples, and the invention is not limited to the embodiments. Members having the substantially same functions through the figures may be given the same reference numeral.

### <First embodiment>

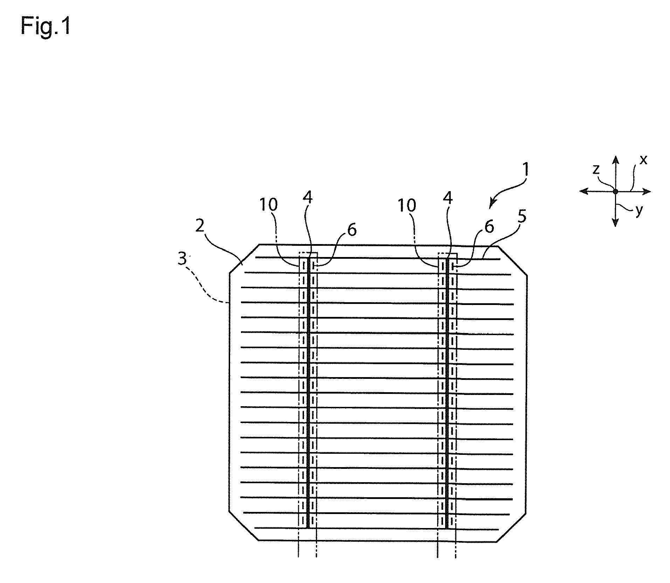

Fig. 1 is a schematic plan view illustrating a first principal surface (light receiving surface) of a solar cell in accordance with First embodiment. As illustrated in Fig. 1, two bus bar electrodes 4 extending in a y-direction are provided on first principal surface 2 of photoelectric conversion body 1a of solar cell 1. Finger electrodes 5 extend in a direction (x-direction) substantially perpendicular to the direction (y-direction) in which bus bar electrodes 4 extend. Accordingly, in this embodiment, finger electrodes 5 and bus bar electrodes 4 extending in a direction intersecting finger electrodes 5 are provided on first principal surface 2 photoelectric conversion body 1a of of solar cell 1. Bus bar electrodes 4 and finger electrodes 5 are similarly formed on second principal surface (back surface) 3. The number of finger electrodes 5 on second principal surface 3 is larger than that of finger electrodes 5 on first principal surface 2.

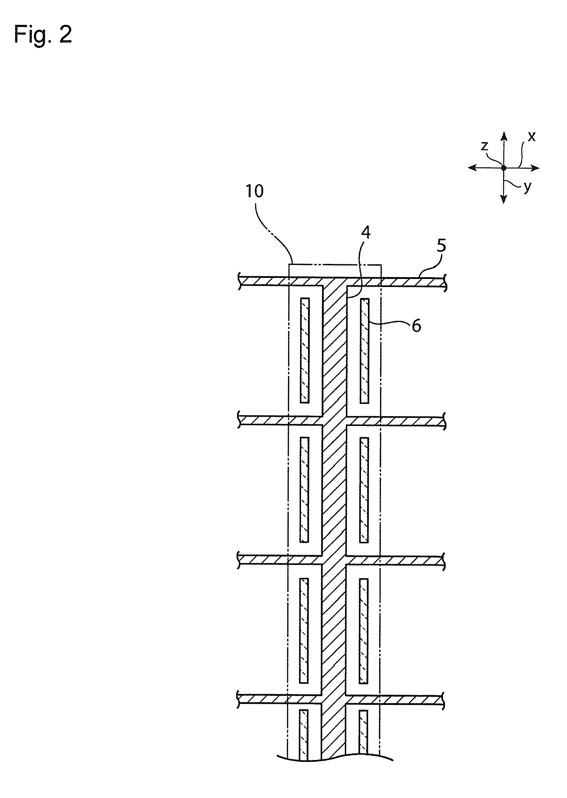

Fig. 2 is a schematic enlarged plan view illustrating bus bar electrodes, finger electrodes, and adhesion assistance portions in First embodiment. As illustrated in Fig. 1 and Fig. 2, adhesion assistance portions 6 are provided near bus bar electrodes 4. As illustrated in Fig. 2, adhesion assistance portions 6 each are shaped like a rectangle extending in the direction in which bus bar electrodes 4 extend (y-direction) between finger electrodes 5. Adhesion assistance portions 6 are provided in regions where wiring members 10 are located when being connected to bus bar electrodes 4 (regions represented by chain double-dashed lines in Fig. 1 and Fig. 2). Accordingly, adhesion assistance portions 6 are located at a position to be in contact with wiring members 10 when wiring members 10 are electrically connected to bus bar electrodes 4.

Adhesion assistance portions 6 contain inorganic particles that are different from conductive particles contained in bus bar electrodes 4 and finger electrodes 5. Colored inorganic particles are preferably used as the inorganic particles. The use of the colored inorganic particles enables visual recognition of adhesion assistance portions 6. White inorganic particles are preferably used as the colored inorganic particles. Specific examples of the white inorganic particles include titanium oxide and aluminum oxide. Adhesion assistance portions 6 can be formed by printing a paste containing binder resin and the inorganic particles. Examples of the binder resin include epoxy resin, acrylic resin, urethane resin, phenol resin, silicone resin, and mixture thereof.

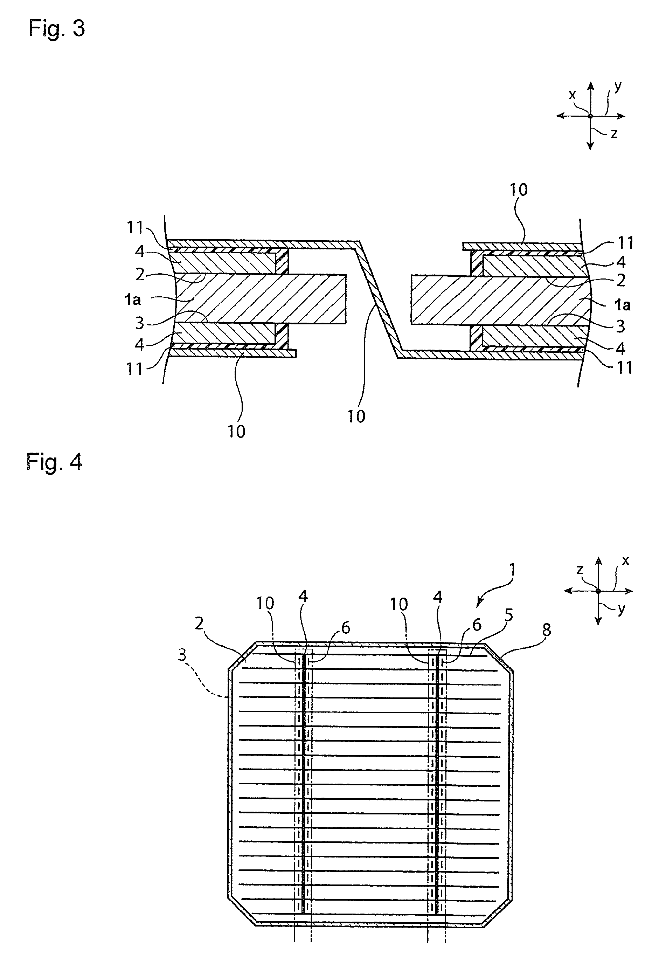

Fig. 3 is a schematic sectional view illustrating connection of the wiring members between adjacent solar cells in a solar cell module in First embodiment. As illustrated in Fig. 3, between adjacent solar cells 1, bus bar electrodes 4 provided on first principal surface 2 on photoelectric conversion body 1a of one solar cell 1 are electrically connected to bus bar electrodes 4 provided on second principal surface 3 of photoelectric conversion body 1a of the other solar cell 1 via wiring members 10. Each bus bar electrode 4 is adhered to wiring member 10 with resin adhesive layer 11.

For example, wiring member 10 can be formed by using a low-resistance material such as copper, silver, and aluminum as a core material, and silver-plating or solder-plating the surface of the core material.

In this embodiment, resin adhesive layer 11 is a resin adhesive layer including a conductive material. However, first bus bar electrode 4 may be electrically connected to wiring member 10 with a resin adhesive layer including no conductive material. In this case, resin adhesive layer 11 is formed so as to cover side surfaces of bus bar electrode 4 and wiring member 10. In this case, bus bar electrode 4 is electrically connected to wiring member 10 through direct contact. Resin adhesive layer 11 may be made of epoxy resin, acrylic resin, urethane resin, phenol resin, silicone resin, or a mixture thereof.

In this embodiment, first principal surface 2 corresponds to a light receiving surface, and second principal surface 3 corresponds to a back surface. Accordingly, first principal surface 2 is located on the light reception side, and second principal surface 3 is located at the back surface side. In manufacturing the solar cell module, a first protective member made of glass or the like is provided on the side of first principal surface 2, and a second protective member formed of a resin sheet or the like is provided on the side of second principal surface 3. A encapsulant made of resin or the like is provided between the first protective member and the second protective member. A solar cell string including solar cells 1 connected to each other via wiring members 10 is filled in the encapsulant.

In this embodiment, adhesion assistance portions 6 are located at positions to be in contact with wiring members 10 when wiring members 10 are electrically connected to bus bar electrodes 4. For this reason, the adhesive strength of wiring members to first principal surface 2 of solar cell 1 can be increased, thereby improving the reliability in connection between wiring members 10 and bus bar electrodes 4.

### <Second embodiment>

Fig. 4 is a schematic plan view illustrating a first principal surface (light receiving surface) of a solar cell in accordance with Second embodiment. In this embodiment, as in First embodiment, bus bar electrodes 4, finger electrodes 5, and adhesion assistance portions 6 are provided on first principal surface 2 of photoelectric conversion body 1a. In this embodiment, reflective portion 8 is formed in an ineffective region on the outer periphery of first principal surface 2. The ineffective region where no pn junction or pin junction is formed is present on the outer periphery of solar cell 1. Light incident on the ineffective region does not contribute to power generation. In this embodiment, reflective portion 8 is formed to reflect light incident on the ineffective region and cause the light to reenter into the effective region of photoelectric conversion body 1a.

Reflective portion 8 can be formed by applying a paste containing a white inorganic pigment such as titanium oxide or aluminum oxide and binder resin.

In this embodiment, adhesion assistance portions 6 are made of the substantially same material as the material for reflective portion 8. Accordingly, in this embodiment, reflective portion 8 for reflecting light incident on the ineffective region is provided in the ineffective region, and adhesion assistance portions 6 are made of the substantially same material as the material for reflective portion 8.

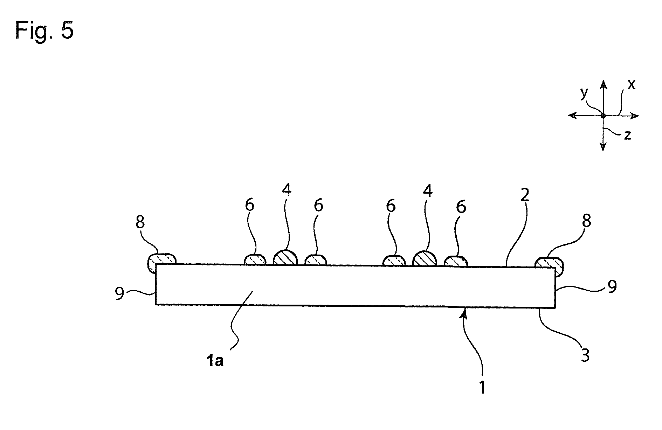

Fig. 5 is a schematic sectional view illustrating the solar cell in Second embodiment. As illustrated in Fig. 5, bus bar electrodes 4 are formed on first principal surface 2 of photoelectric conversion body 1a, and adhesion assistance portions 6 are formed near respective bus bar electrodes 4. Reflective portion 8 is formed in an ineffective region on the outer periphery of photoelectric conversion body 1a. Reflective portion 8 is also formed on an upper portion of side surface 9 of solar cell 1.

As described above, in this embodiment, adhesion assistance portions 6 are made of the substantially same material as the material for reflective portion 8. Accordingly, adhesion assistance portions 6 and reflective portion 8 in this embodiment can be formed in the same step. Specifically, a paste for adhesion assistance portions 6 and reflective portion 8 is printed by screen printing to form adhesion assistance portions 6 and reflective portion 8 at the same time. If adhesion assistance portions 6 and reflective portion 8 are formed in the same step as in this embodiment, inorganic particles such as white inorganic pigment are used for both reflective portion 8 and adhesion assistance portions 6. Further, the same binder resin is used for both reflective portion 8 and adhesion assistance portions 6.

Also in this embodiment, since adhesion assistance portions 6 are provided, the adhesive strength of wiring members to first principal surface 2 of solar cell 1 can be increased, thereby improving the reliability in connection between wiring members 10 and bus bar electrodes 4.

### <Third embodiment>

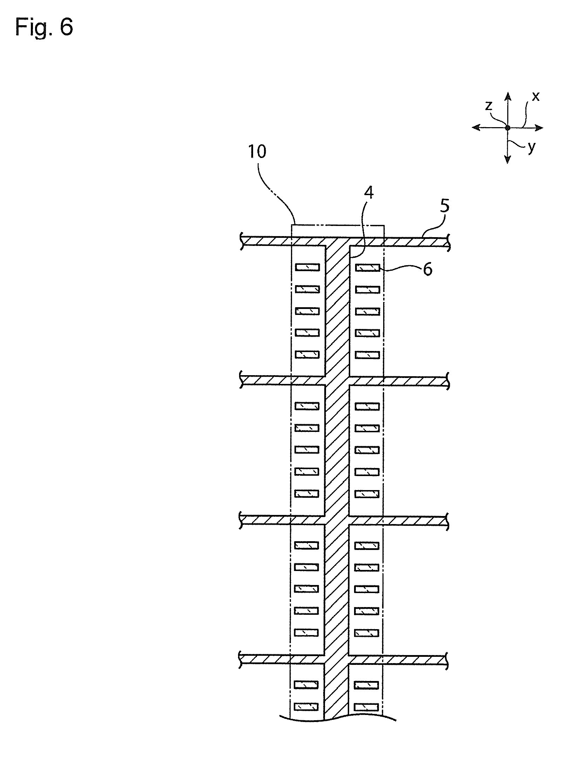

Fig. 6 is a schematic enlarged plan view illustrating bus bar electrodes, finger electrodes, and adhesion assistance portions in Third embodiment.

In this embodiment, adhesion assistance portions 6 each are shaped like a rectangle extending in the direction in which finger electrodes 5 extend (x-direction). Such adhesion assistance portions 6 are arranged in the direction in which bus bar electrodes 4 extend (y-direction), between finger electrodes 5.

Also in this embodiment, since adhesion assistance portions 6 are provided, the adhesive strength of wiring members to first principal surface 2 of solar cell 1 can be increased, thereby improving the reliability in connection between wiring members 10 and bus bar electrodes 4.

### <Fourth embodiment>

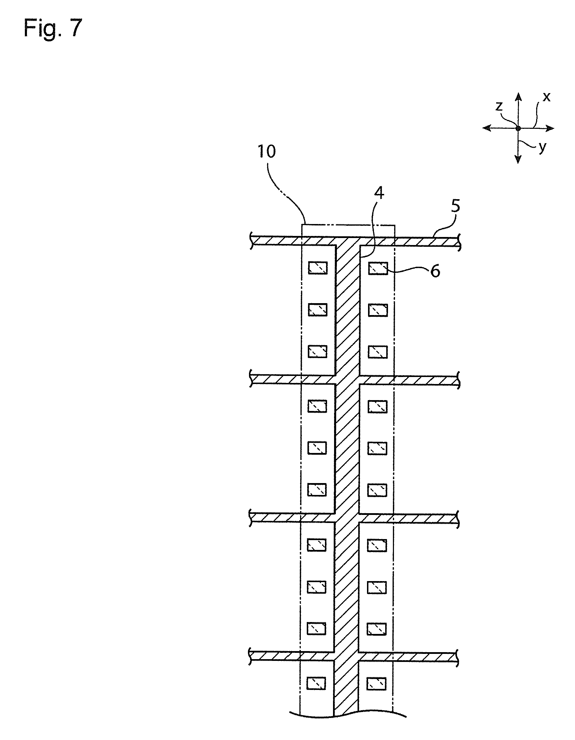

Fig. 7 is a schematic enlarged plan view illustrating bus bar electrodes, finger electrodes, and adhesion assistance portions in Fourth embodiment.

In this embodiment, adhesion assistance portions 6 each are shaped like a rectangle extending in the direction in which finger electrodes 5 extend (x-direction). This rectangle is longer than the rectangle of adhesion assistance portion 6 in Third embodiment in the direction in which bus bar electrodes 4 extend (y-direction). Such adhesion assistance portions 6 are arranged in the direction in which bus bar electrodes 4 extend (y-direction), between finger electrodes 5.

Also in this embodiment, since adhesion assistance portions 6 are provided, the adhesive strength of wiring members to first principal surface 2 of solar cell 1 can be increased, thereby improving the reliability in connection between wiring members 10 and bus bar electrodes 4.

### <Fifth embodiment>

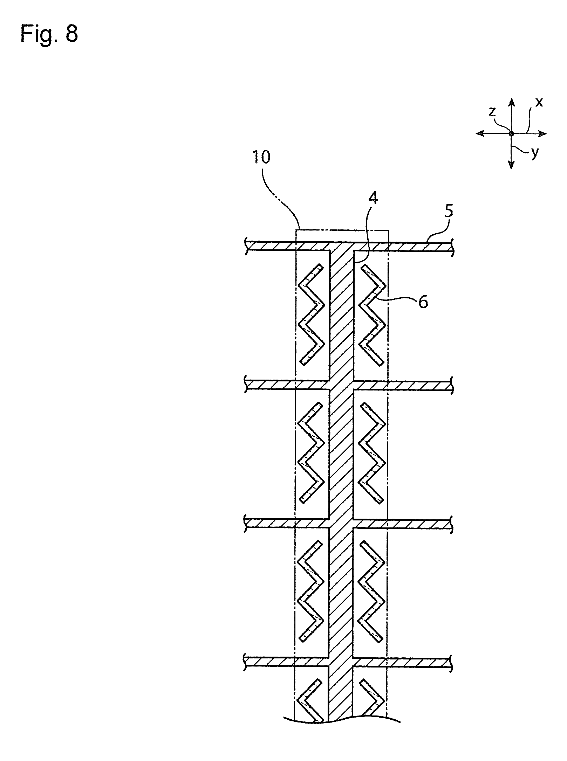

Fig. 8 is a schematic enlarged plan view illustrating bus bar electrodes, finger electrodes, and adhesion assistance portions in Fifth embodiment.

In this embodiment, adhesion assistance portions 6 each extend in the y-direction in a zigzag pattern. To print finger electrodes 5 and bus bar electrodes 4 by screen printing, typically, a squeegee is moved in the x-direction. Adhesion assistance portions 6 can be similarly formed in a zigzag pattern by screen printing, preventing printing breakage. Moreover, adhesion assistance portions 6 in the zigzag pattern can be adhered to wiring members 10 more widely.

Also in this embodiment, since adhesion assistance portions 6 are provided, the adhesive strength of wiring members to first principal surface 2 of solar cell 1 can be increased, thereby improving the reliability in connection between wiring members 10 and bus bar electrodes 4.

### <Sixth embodiment>

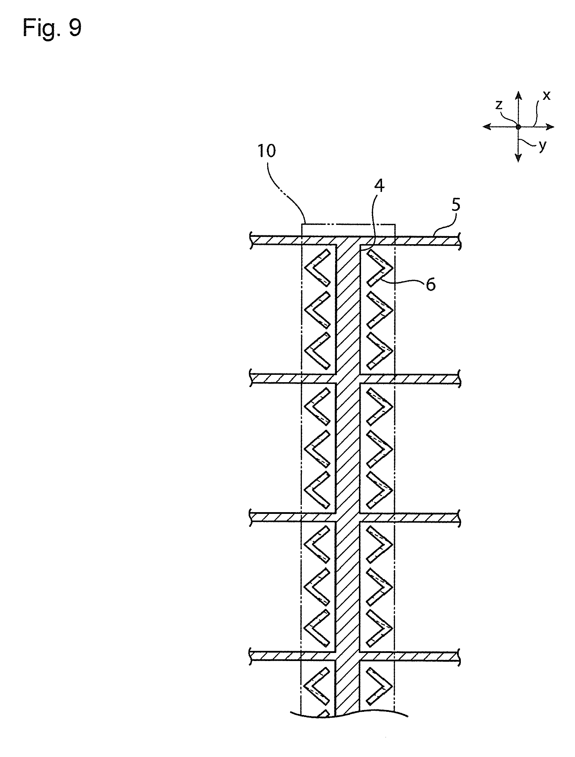

Fig. 9 is a schematic enlarged plan view illustrating bus bar electrodes, finger electrodes, and adhesion assistance portions in Sixth embodiment.

In this embodiment, L-like adhesion assistance portions 6 are arranged. Each L-like adhesion assistance portion 6 is inclined so as to the corner is oriented to the outside. As in Fifth embodiment, adhesion assistance portions 6 of such shape can be formed by screen printing with less printing breakage. Moreover, adhesion assistance portions 6 can be adhered to wiring members 10 more widely.

Also in this embodiment, since adhesion assistance portions 6 are provided, the adhesive strength of wiring members to first principal surface 2 of solar cell 1 can be increased, thereby improving the reliability in connection between wiring members 10 and bus bar electrodes 4.

In Third to Sixth embodiments, as in Second embodiment, reflective portion 8 is provided in the ineffective region on the outer periphery of photoelectric conversion body 1a of solar cell 1.

The shape and number of adhesion assistance portions 6 are not limited to those in the embodiments. Although adhesion assistance portions 6 are formed on first principal surface 2 in the embodiments, adhesion assistance portions 6 may be formed on second principal surface 3.

Although the solar cell has bus bar electrodes 4 in the embodiments, the invention is not limited to this. That is, a so-called bus bar-less solar cell, which includes no bus bar electrode 4 is possible. In this case, wiring members 10 are electrically connected to finger electrodes 5.

## Claims

1. A solar cell module comprising:
adjacent solar cells; and
a wiring member electrically connects the adjacent solar cells to each other with resin adhesive, wherein
each solar cell comprises:
a photoelectric conversion body:
a finger electrode provided on a principal surface of the photoelectric conversion body; and
an adhesion assistance portion provided at a position where the wiring member overlaps with a photoelectric conversion body when being electrically connected to the solar cell with the resin adhesive, the adhesion assistance portion containing an inorganic particle other than a conductive particle contained in the finger electrode.

2. The solar cell module according to claim 1, wherein each solar cell further comprises a bus bar electrode provided on the principal surface of the photoelectric conversion body and extending in a direction intersecting the finger electrode, wherein
the wiring member is electrically connected to the bus bar electrode with the resin adhesive.

3. The solar cell module according to claim 1 or 2, wherein
the photoelectric conversion body includes an ineffective region that does not contribute to power generation,
a reflective portion is provided on the ineffective region and is configured to reflect light incident toward the ineffective region, and
the adhesion assistance portion is made of the substantially same material as the reflective portion.

4. The solar cell module according to any one of claims 1 to 3, wherein
the inorganic particle is a colored inorganic particle.

5. The solar cell module according to claim 4, wherein
the colored inorganic particle is a white inorganic particle.

6. The solar cell module according to any one of claims 1 to 5, wherein
the adhesion assistance portion does not overlap with the bus bar electrode or the finger electrode.

7. A solar cell to be electrically connected to an adjacent solar cell via a wiring member, the solar cell comprising:
a photoelectric conversion body:
a finger electrode provided on a principal surface of the photoelectric conversion body; and
an adhesion assistance portion provided at a position where the wiring member is to be overlapped with the photoelectric conversion body when being electrically connected to the solar cell with a resin adhesive, the adhesion assistance portion containing an inorganic particle other than a conductive particle contained in the finger electrode.

8. A method of manufacturing a solar cell to be electrically connected to an adjacent solar cell via a wiring member, the method comprising:
forming a finger electrode on a principal surface of a photoelectric conversion body; and
providing an adhesion assistance portion on the photoelectric conversion body at a position to be overlapped with the wiring member, the adhesion assistance portion containing an inorganic particle other than a conductive particles contained in the finger electrode.

9. The solar cell manufacturing method according to claim 8, further comprising forming a bus bar electrode extending in a direction intersecting the finger electrode on the principal surface of the solar cell, wherein
the wiring member is electrically to be connected to the bus bar electrode with the resin adhesive.

10. The solar cell manufacturing method according to claim 8 or 9, further comprising forming a reflective portion on an ineffective region which is formed in the photoelectric conversion body and makes no contribution to power generation, the reflective portion configured to reflect light incident toward the ineffective region.

11. The solar cell manufacturing method according to claim 10, wherein
the adhesion assistance portion and the reflective portion are formed in the same step.

12. The solar cell manufacturing method according to claim 8, further comprising:
electrically connecting the wiring member to the solar cell with a resin adhesive.
